# EUROPEAN PATENT APPLICATION

(11) **EP 4 465 282 A1**
(43) Date of publication of application: **20.11.2024**
(21) Application number: 24150395.2
(22) Date of filing: 04.01.2024
(51) Int. Cl.: G09F 9/302

(54) **EDGE LOCKING APPARATUS OF LED DISPLAY SCREEN AND LED DISPLAY SCREEN**

(30) Priority: 17.05.2023 CN 202310558666
(71) Applicant: Leyard Optoelectronic Co., Ltd, Beijing 100091 (CN)
(72) Inventor: WANG, Dingfang, Beijing, 100091 (CN); LU, Changjun, Beijing, 100091 (CN); LIU, Zhiyong, Beijing, 100091 (CN)
(74) Representative: HGF

(57) **Abstract**

The invention provides an edge locking apparatus of a Light Emitting Diode (LED) display screen and the LED display screen. The edge locking apparatus of the LED display screen includes an edge locking structure (10). The edge locking structure (10) includes a lock seat (11), a lock cylinder (12), a rotating piece (13), a first driving piece (13) and a second driving piece (14). The lock cylinder (12) is movably arranged in the lock seat (11), and the lock cylinder (12) includes a cylinder body part (121), and a lock pin (122), a first rotating part (123), an avoiding part (124) and a second rotating part (125) which are sequentially arranged on the cylinder body part (121) at intervals. The cylinder body part (121) is provided with a retracting position enabling the lock pin (122) to retract into the lock seat (11), an inserting position enabling the lock pin to extend out of the lock seat and a locking position enabling the lock pin to rotate by a preset angle relative to the inserting position. The rotating piece (13) is rotatably arranged on the lock seat and the rotating piece (13) and the first rotating part (14) are able to rotate synchronously. The first driving piece (14) is movably arranged on the cylinder body part. The second driving piece (15) is rotatably arranged on the lock seat and the second driving piece and the second rotating part are able to rotate synchronously. The technical solution of the invention effectively solves the problem in the related art that the edge locking structure is prone to loosening, so that the locking effect is poor.

## Description

### Cross Reference to Related Applications

The present invention claims benefit of Chinese Patent Application No. 202310558666.8, filed on May 17, 2023, entitled "Edge Locking Apparatus of LED Display Screen and LED Display Screen", the contents of which are hereby incorporated by reference in its entirety.

### Technical Field

The invention relates to the technical field of Light Emitting Diode (LED) display, and in particular to an edge locking apparatus of an LED display screen and the LED display screen.

### Background

With the increasing maturity of LED display technology, the application of large-screen LED display screens is becoming more and more common. Usually, the large-screen LED display screen requires a combination of a plurality of display modules, and an edge locking structure is commonly used to lock two LED frames behind the adjacent display modules, so as to make the plurality of display modules as a whole.

However, the above edge locking structure includes a lock seat arranged on one LED frame, a lock cylinder movably arranged on the lock seat and a driving piece driving the lock cylinder to move. The driving piece drives the lock cylinder to move, so that the lock cylinder is provided with an inserting position inserted into the other LED frame and a locking position rotating by a preset angle to lock the other LED frame. Because the lock cylinder only drives the lock cylinder to move through the single-stage driving piece, the edge locking structure is prone to looseness, so that the locking effect is poor.

### Summary

The main purpose of the invention is to provide an edge locking apparatus of an LED display screen and the LED display screen, so as to effectively solve the problem in the related art that an edge locking structure is prone to loosening, so that the locking effect is poor.

In order to achieve the above purpose, according to one aspect of the invention, an edge locking apparatus of an LED display screen is provided. The edge locking apparatus of the LED display screen includes an edge locking structure. The edge locking structure includes a lock seat, a lock cylinder, a rotating piece, a first driving piece and a second driving piece. The lock cylinder is movably arranged in the lock seat, and the lock cylinder includes a cylinder body part, and a lock pin, a first rotating part, an avoiding part and a second rotating part which are sequentially arranged on the cylinder body part at intervals. The cylinder body part is provided with a retracting position enabling the lock pin to retract into the lock seat, an inserting position enabling the lock pin to extend out of the lock seat and a locking position enabling the lock pin to rotate by a preset angle relative to the inserting position. The rotating piece is rotatably arranged on the lock seat, and the rotating piece and the first rotating part are able to rotate synchronously. The first driving piece is movably arranged on the cylinder body part and drives the cylinder body part to move in an extending or retracting direction of the lock pin, when the cylinder body part is in the retracting position, the first rotating part and the rotating piece rotate synchronously, and when the cylinder body part is in the inserting position, the avoiding part corresponds to the rotating piece. The second driving piece is rotatably arranged on the lock seat and the second driving piece and the second rotating part are able to rotate synchronously, when the cylinder body part is in the inserting position, the second driving piece and the second rotating part rotate synchronously, and the first driving piece drives the rotating piece to rotate to drive the second driving piece to rotate, so that the cylinder body part rotates from the inserting position to the locking position.

Further, the first driving piece includes a first connecting rod and a second connecting rod. A first drive shaft is connected with the cylinder body part, the first connecting rod is provided with a first limiting slot hole, and the first drive shaft is arranged in the first limiting slot hole. A second drive shaft is connected with the rotating piece, a first end of the second connecting rod is hinged to the first connecting rod, a second end of the second connecting rod is provided with a second limiting slot hole, and the second drive shaft is located in the second limiting slot hole.

Further, the first connecting rod includes a first force application rod segment and a first driving rod segment which are fixedly connected at an angle. The first end of the second connecting rod is hinged to the first force application rod segment, the first limiting slot hole is arranged on the first driving rod segment, and the first force application rod segment drives the first driving rod segment to swing to drive the first drive shaft to move, so that the cylinder body part is switched between the retracting position and the inserting position. The second end of the second connecting rod drives the second drive shaft to move in the second limiting slot hole, so that the cylinder body part is switched between the inserting position and the locking position, and the first connecting rod moves relative to the first drive shaft through the first limiting slot hole.

Further, the second connecting rod includes a second force application rod segment and a second driving rod segment which are fixedly connected at an angle. The second force application rod segment is hinged to the first force application rod segment, the second driving rod segment is connected with an end, away from the first force application rod segment, of the second force application rod segment, the second limiting slot hole is arranged on the second driving rod segment, and a length direction of the second limiting slot hole is perpendicular to a length direction of the first limiting slot hole.

Further, the lock seat includes a seat body and a mounting channel arranged in the seat body. The cylinder body part is movably mounted in the mounting channel, and the mounting channel is provided with a first opening for allowing the cylinder body part to pass through. The lock seat further includes a cover plate covering the first opening. The cover plate is provided with an avoiding hole for allowing the cylinder body part to pass through. A side wall of the mounting channel includes a first arc-shaped concave surface in sliding fit with the rotating piece and a second arc-shaped concave surface in sliding fit with the second driving piece. The mounting channel is provided with a stopper, and the second driving piece and the rotating piece are located between the stopper and the cover plate.

Further, the lock seat is provided with a limiting groove communicating with the mounting channel, and the limiting groove is located on a side, away from the cover plate, of the stopper. The lock cylinder further includes a cylinder seat movably arranged in the limiting groove. The cylinder seat is connected with an end, away from the lock pin, of the cylinder body part through an axial limiting structure, the cylinder body part is rotatably arranged relative to the cylinder seat, the first driving piece is movably arranged on the cylinder body part through the cylinder seat, the cylinder seat is provided with a first limiting position and a second limiting position in the limiting groove, when the cylinder seat is in the first limiting position, the cylinder body part is in the retracting position, and when the cylinder seat is in the second limiting position, the cylinder body part is in the inserting position.

Further, the axial limiting structure includes a limiting ring groove arranged on the cylinder body part and a limited block inserted into the limiting ring groove. The limited block and the limiting ring groove are in limiting fit in an axial direction of the cylinder body part.

Further, the second driving piece includes a driving disc rotatably arranged on the lock seat and a third connecting rod hinged between the driving disc and the rotating piece. The driving disc sleeves the lock cylinder. The lock seat includes a mounting plate located between the driving disc and the rotating piece. The third connecting rod is arranged on the mounting plate in a swingable manner, the driving disc and the second rotating part are able to rotate synchronously, when the second driving piece is driven by the rotating piece, the rotating piece rotates and drives the driving disc to rotate in a direction opposite to a rotation direction of the rotating piece through the third connecting rod, so that the cylinder body part is switched between the inserting position and the locking position.

Further, a third drive shaft is connected with the rotating piece, a first end of the third connecting rod is provided with a third limiting slot hole, the third drive shaft is arranged in the third limiting slot hole, a fourth drive shaft is connected with the driving disc, a second end of the third connecting rod is provided with a fourth limiting slot hole, and the fourth drive shaft is arranged in the fourth limiting slot hole.

Further, the edge locking apparatus of the LED display screen further includes a pulling assembly arranged outside the lock seat and a reset piece connected between the first driving piece and the lock seat. The reset piece applies a reset force to maintain the first driving piece in the retracting position. An end of the pulling assembly is connected with the first driving piece, and the pulling assembly applies a pulling force to switch the first driving piece from the retracting position to the inserting position.

Further, the pulling assembly includes a pulling seat, a pulling plate and a pulling wire. The pulling seat is arranged outside the lock seat, the pulling plate is rotatably arranged on the pulling seat, a first end of the pulling wire is connected with the first driving piece, a second end of the pulling wire is connected with the pulling plate through a connecting shaft, the connecting shaft and a rotating axis of the pulling plate are arranged at intervals, so that the second end of the pulling wire rotates around the rotating axis of the pulling plate, and the pulling wire applies a pulling force to the first driving piece.

The pulling assembly further includes a stop structure spaced apart from the pulling seat. The stop structure includes a stop seat and a stop pin movably arranged on the stop seat. Both ends of the pulling plate are respectively provided with a first socket and a second socket matched with the stop pin, the connecting shaft is located between the rotating axis of the pulling plate and the second socket, when the stop pin is inserted into the first socket, the cylinder body part is maintained in the retracting position under the action of the reset force, and when the stop pin is inserted into the second socket, the cylinder body part is maintained in the locking position under the action of the pulling force.

According to another aspect of the invention, an LED display screen is provided, which includes a first LED frame, a second LED frame and an edge locking apparatus. The first LED frame and the second LED frame are arranged side by side or up-down, the edge locking apparatus is the above edge locking apparatus of the LED display screen, an edge locking structure of the edge locking apparatus is mounted on a first side edge, adjacent to the second LED frame, of the first LED frame, a second side edge, adjacent to the first LED frame, of the second LED frame is provided with a lock hole for allowing a lock pin of the edge locking structure to pass through, and when a cylinder body part is in a locking position, the lock pin and the lock hole are staggered and in stopping fit with the second side edge.

According to another aspect of the invention, an LED display screen is provided, which includes a first LED frame, a second LED frame and an edge locking apparatus. The first LED frame and the second LED frame are arranged side by side or up-down, the edge locking apparatus is the above edge locking apparatus of the LED display screen, an edge locking structure of the edge locking apparatus is mounted on a first side edge, adjacent to the second LED frame, of the first LED frame, and a pulling assembly of the edge locking apparatus is mounted on a third side edge, adjacent to the first side edge, of the first LED frame.

By applying the technical solution of the invention, the edge locking apparatus of the LED display screen includes the edge locking structure. The edge locking structure of the edge locking apparatus of the LED display screen may be mounted on one of two adjacent side edges of the two adjacent LED frames. The edge locking structure includes the lock seat, the lock cylinder, the rotating piece, the first driving piece and the second driving piece. The lock cylinder is movably arranged in the lock seat, and the lock cylinder includes the cylinder body part, and the lock pin, the first rotating part, the avoiding part and the second rotating part which are sequentially arranged on the cylinder body part at intervals. The cylinder body part is provided with the retracting position enabling the lock pin to retract into the lock seat, the inserting position enabling the lock pin to extend out of the lock seat and the locking position enabling the lock pin to rotate by a preset angle relative to the inserting position. The rotating piece is rotatably arranged on the lock seat, and the rotating piece and the first rotating part are able to rotate synchronously. The first driving piece is movably arranged on the cylinder body part and drives the cylinder body part to move in the extending or retracting direction of the lock pin, when the cylinder body part is in the retracting position, the first rotating part and the rotating piece rotate synchronously, and the first rotating part and the rotating piece rotate synchronously to prevent the first rotating part from rotating relative to the rotating piece, so that the cylinder body part only moves between the retracting position and the inserting position relative to the rotating piece. When the cylinder body part is in the inserting position, the avoiding part corresponds to the rotating piece. At this time, the lock pin is inserted into the other of two adjacent side edges of the two adjacent LED frames, and the cylinder body part is movable relative to the rotating piece. The second driving piece is rotatably arranged on the lock seat and the second driving piece and the second rotating part are able to rotate synchronously, when the cylinder body part is in the inserting position, the second driving piece and the second rotating part rotate synchronously to prevent the second driving piece from rotating relative to the second rotating part, and the first driving piece drives the rotating piece to rotate to drive the second driving piece to rotate, so that the cylinder body part rotates from the inserting position to the locking position. At this time, the lock pin locks the other of two adjacent side edges of the two adjacent LED frames to lock the two adjacent LED frames together. In this way, the first driving piece drives the rotating piece to rotate to drive the second driving piece to achieve multi-stage linkage, so as to drive the cylinder body part to rotate to the locking position, thereby avoiding from driving the lock cylinder to move only through the single-stage driving piece. Through the multi-stage linkage, the cylinder body part is driven to rotate, so that the edge locking structure is stable and not prone to loosening, and the locking effect is improved. Therefore, the technical solution of the invention effectively solves the problem in the related art that the edge locking structure is prone to loosening, so that the locking effect is poor.

### Brief Description of the Drawings

The accompanying drawings of the specification, which constitute a part of the invention, are intended to provide a further understanding of the invention, and the exemplary embodiments of the invention and the description thereof are intended to explain the invention and do not constitute an undue limitation on the invention. In the accompanying drawings:
Fig. 1 shows a schematic diagram of a three-dimensional structure of an embodiment of an edge locking structure of an LED display screen when a cylinder body part of the edge locking structure is in a retracting position according to the invention.
Fig. 2 shows a perspective diagram of an edge locking structure of an LED display screen in Fig. 1 after removing a cover plate.
Fig. 3 shows a schematic diagram of a three-dimensional structure of a lock cylinder and a cover plate when a cylinder body part of an edge locking structure of an LED display screen in Fig. 1 is in an inserting position.
Fig. 4 shows a perspective diagram when a cylinder seat of an edge locking apparatus of an LED display screen in Fig. 1 is located in a lock seat.
Fig. 5 shows a schematic diagram of a decomposition structure of a partial structure of an edge locking structure of an LED display screen in Fig. 1.
Fig. 6 shows a schematic diagram of a decomposition structure of a partial structure of an edge locking structure of an LED display screen in Fig. 5.
Fig. 7 shows a schematic diagram of a three-dimensional structure of a pulling assembly of an edge locking structure of an LED display screen in Fig. 1.
Fig. 8 shows a schematic diagram of a decomposition structure of a partial structure of a pulling assembly of an edge locking structure of an LED display screen in Fig. 7.
Fig. 9 shows a schematic diagram of a three-dimensional structure when a cylinder body part of an edge locking structure of an LED display screen in Fig. 1 is in an inserting position.
Fig. 10 shows a schematic diagram of a three-dimensional structure when a cylinder body part of an edge locking structure of an LED display screen in Fig. 1 is in a locking position.
Fig. 11 shows a schematic diagram of a three-dimensional structure when a cylinder body part of an edge locking structure of an LED display screen in Fig. 1 is in a tensioning position.
Fig. 12 shows a schematic diagram of a three-dimensional structure of an embodiment of an LED display screen according to the invention.
Fig. 13 shows a schematic diagram of a three-dimensional structure of a first LED frame and an edge locking structure of an LED display screen in Fig. 12.
Fig. 14 shows a local enlarged diagram of a place A of an LED display screen in Fig. 13.
Fig. 15 shows a local enlarged diagram of a place B of an LED display screen in Fig. 13.

Herein, the above accompanying drawings include the following reference signs.
10: Edge locking structure;
11: Lock seat; 111: Mounting plate; 1111: Limiting arc-shaped hole; 112: Cover plate; 1121: Avoiding hole; 113: Second abutting inclined surface; 114: Limiting groove; 115: Seat body; 116: Protective seat; 117: Mounting channel; 1171: First arc-shaped concave surface; 1172: Second arc-shaped concave surface;
12: Lock cylinder; 121: Cylinder body part; 122: Lock pin; 123: First rotating part; 124: Avoiding part; 125: Second rotating part; 126: First drive shaft; 127: Cylinder seat; 128: Axial limiting structure; 1281: Limiting ring groove; 1282: Limited block;
13: Rotating piece; 131: Second drive shaft; 132: Third drive shaft; 133: Rotation stopping plate; 134: First abutting inclined surface;
14: First driving piece; 141: First connecting rod; 1411: First force application rod segment; 1412: First driving rod segment; 1413: First limiting slot hole; 142: Second connecting rod; 1421: Second force application rod segment; 1422: Second driving rod segment; 1423: Second limiting slot hole;
15: Second driving piece; 151: Driving disc; 152: Third connecting rod; 153: Third limiting slot hole; 154: Second opening; 155: Fourth limiting slot hole; 156: Fourth drive shaft; 16: Stopper;
21: First LED frame; 211: Third side edge; 22: Second LED frame; 23: Lock hole;
31: Pulling assembly; 311: Pulling seat; 312: Pulling plate; 313: Pulling wire; 314: Connecting shaft; 315: First socket; 316: Second socket; 32: Stop structure; 321: Stop seat; 322: Stop pin; 323: Elastic piece; 33: Reset piece.

### Detailed Description of the Embodiments

The technical solutions in the embodiments of the invention will be clearly and completely described in conjunction with the accompanying drawings in the embodiments of the invention. It is apparent that the described embodiments are only a part of the embodiments of the invention, and not all of them. The following description of at least one exemplary embodiment is only illustrative, and in no way serves as any limitation on the invention or application or use thereof. All other embodiments obtained by those of ordinary skill in the art based on the embodiments of the invention without creative efforts are within the scope of protection of the invention.

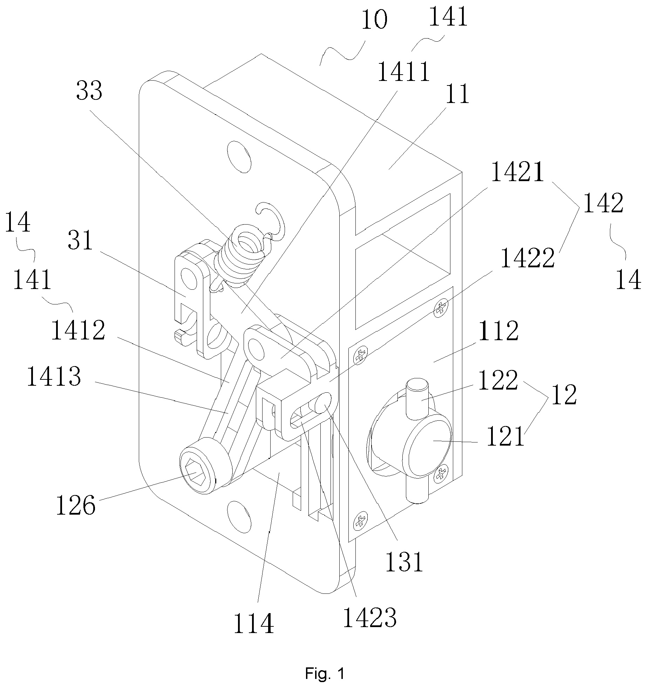

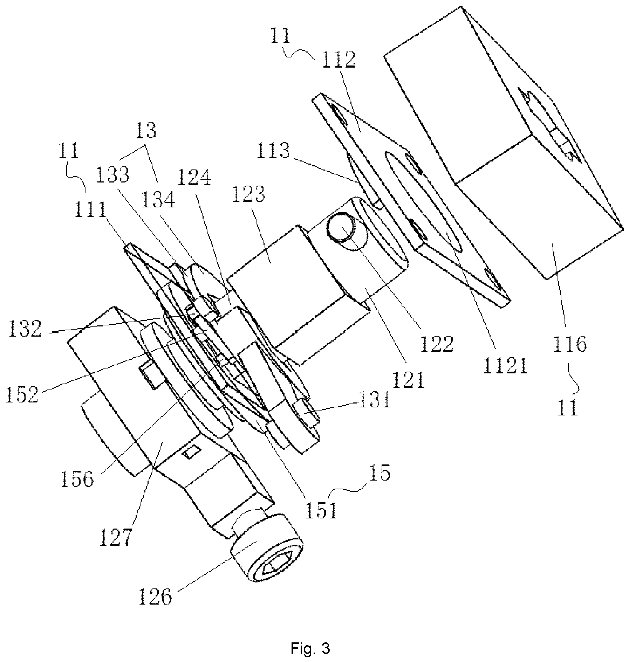

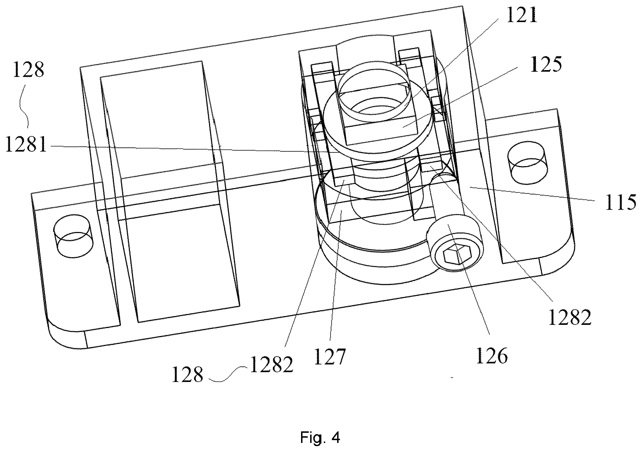

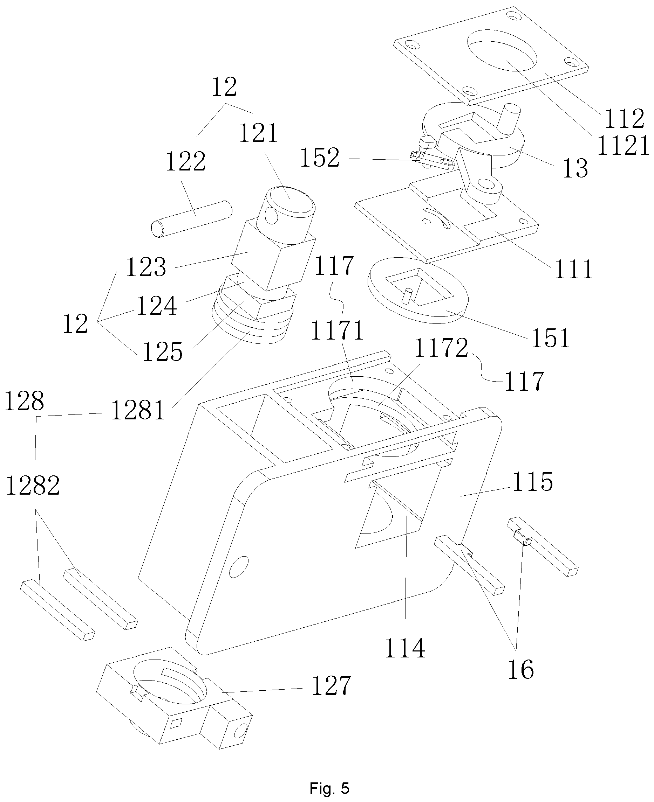

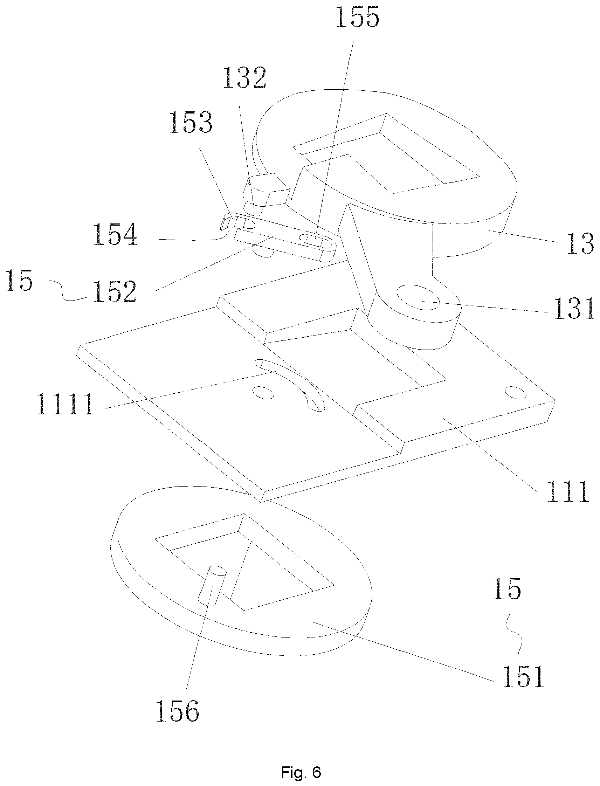

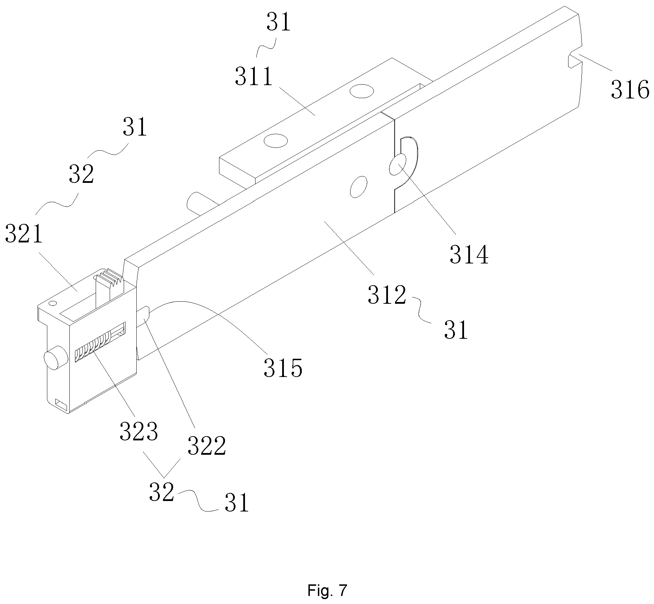

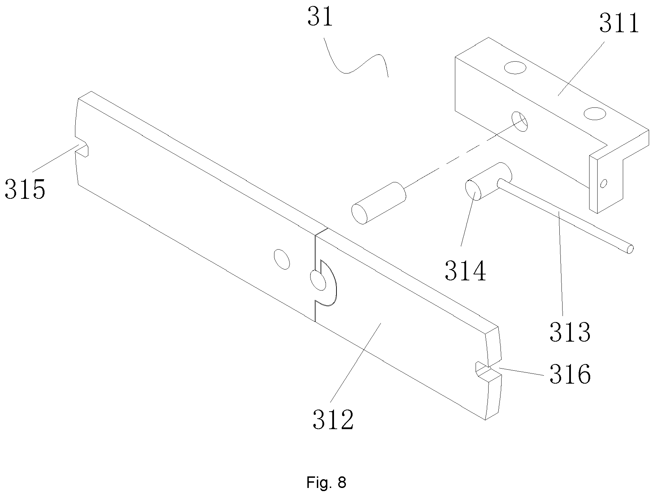

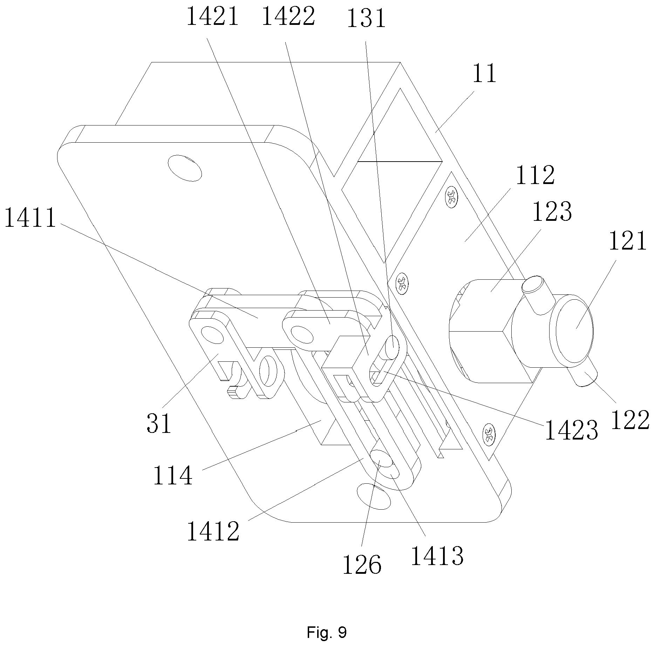

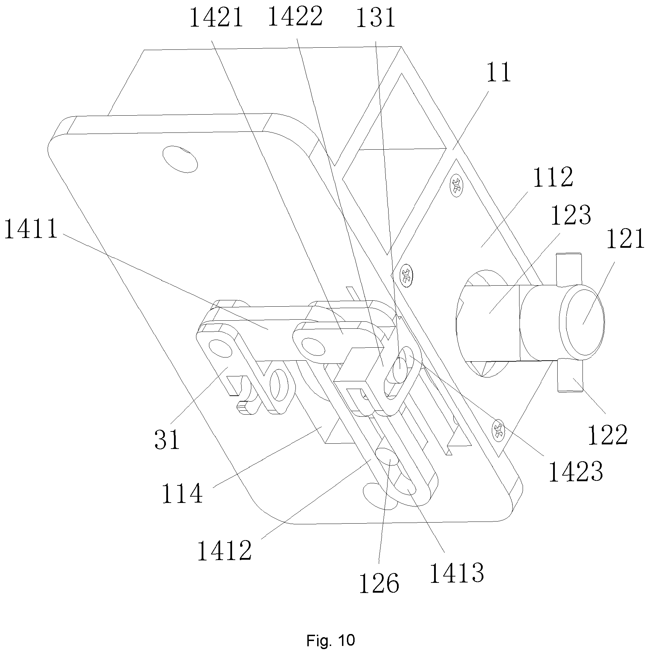

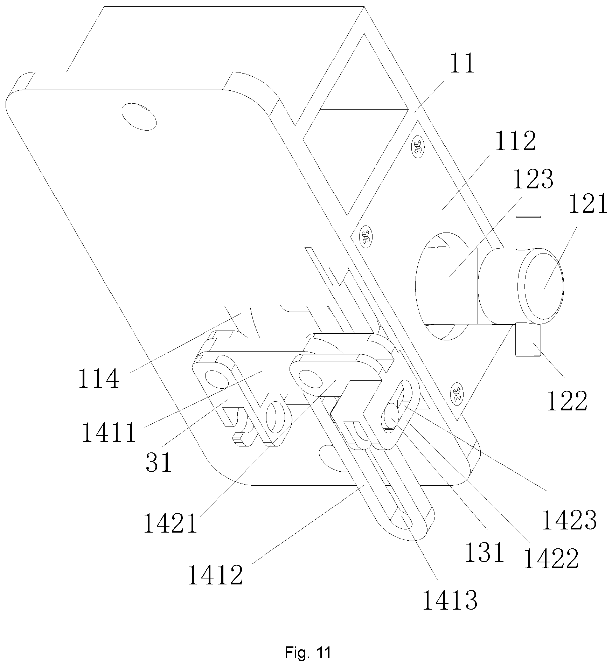

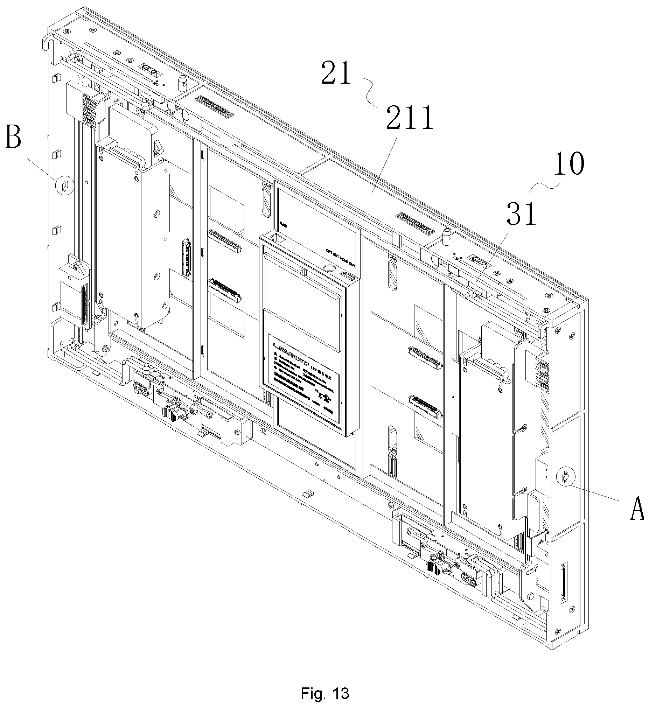

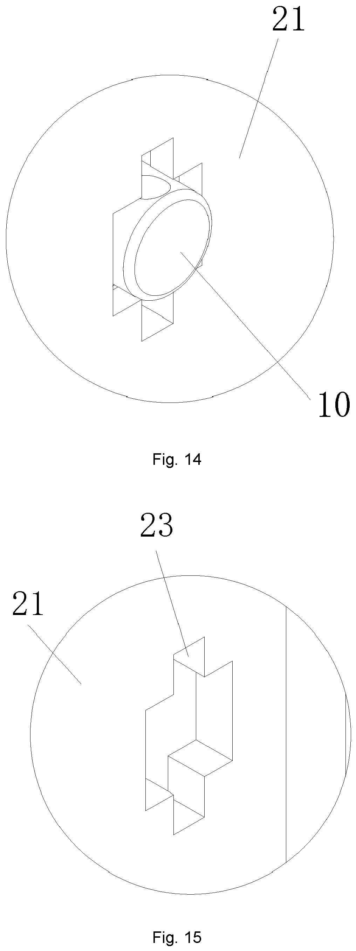

As shown in Fig. 1 to Fig. 15, an edge locking apparatus of an LED display screen in the embodiment includes an edge locking structure 10. The edge locking structure 10 includes a lock seat 11, a lock cylinder 12, a rotating piece 13, a first driving piece 14 and a second driving piece 15. The lock cylinder 12 is movably arranged in the lock seat 11, and the lock cylinder 12 includes a cylinder body part 121, and a lock pin 122, a first rotating part 123, an avoiding part 124 and a second rotating part 125 which are sequentially arranged on the cylinder body part 121 at intervals. The cylinder body part 121 is provided with a retracting position enabling the lock pin 122 to retract into the lock seat 11, an inserting position enabling the lock pin 122 to extend out of the lock seat 11 and a locking position enabling the lock pin to rotate by a preset angle relative to the inserting position. The rotating piece 13 is rotatably arranged on the lock seat 11 and the rotating piece 13 and the first rotating part 123 are able to rotate synchronously. The first driving piece 14 is movably arranged on the cylinder body part 121 and drives the cylinder body part 121 to move in an extending or retracting direction of the lock pin, when the cylinder body part 121 is in the retracting position, the first rotating part 123 and the rotating piece 13 rotate synchronously, and when the cylinder body part 121 is in the inserting position, the avoiding part 124 corresponds to the rotating piece 13. The second driving piece 15 is rotatably arranged on the lock seat 11 and the second driving piece 15 and the second rotating part 125 are able to rotate synchronously, when the cylinder body part 121 is in the inserting position, the second driving piece 15 and the second rotating part 125 rotate synchronously, and the first driving piece 14 drives the rotating piece 13 to rotate to drive the second driving piece 15 to rotate, so that the cylinder body part 121 rotates from the inserting position to the locking position.

By applying the technical solution of the embodiment, the edge locking apparatus of the LED display screen includes the edge locking structure 10. The edge locking structure 10 of the edge locking apparatus of the LED display screen may be mounted on one of two adjacent side edges of the two adjacent LED frames. The edge locking structure 10 includes the lock seat 11, the lock cylinder 12, the rotating piece 13, the first driving piece 14 and the second driving piece 15. When the cylinder body part 121 is in the retracting position, the first rotating part 123 and the rotating piece 13 rotate synchronously, and the first rotating part 123 and with the rotating piece 13 rotate synchronously to prevent the first rotating part 123 from rotating relative to the rotating piece 13, so that the cylinder body part 121 only moves between the retracting position and the inserting position relative to the rotating piece 13. When the cylinder body part 121 is in the inserting position, the avoiding part 124 corresponds to the rotating piece 13. At this time, the lock pin 122 is inserted into the other of two adjacent side edges of the two adjacent LED frames, and the cylinder body part 121 is movable relative to the rotating piece 13. The second driving piece 15 is rotatably arranged on the lock seat 11 and the second driving piece 15 and the second rotating part 125 are able to rotate synchronously, when the cylinder body part 121 is in the inserting position, the second driving piece 15 and the second rotating part 125 rotate synchronously to prevent the second driving piece 15 from rotating relative to the second rotating part 125, and the first driving piece 14 drives the rotating piece 13 to rotate to drive the second driving piece 15 to rotate, so that the cylinder body part 121 rotates from the inserting position to the locking position. At this time, the lock pin 122 locks the other of two adjacent side edges of the two adjacent LED frames to lock the two adjacent LED frames together. In this way, the first driving piece 14 drives the rotating piece 13 to rotate to drive the second driving piece 15 to achieve multi-stage linkage, so as to drive the cylinder body part 121 to rotate to the locking position, thereby avoiding driving the lock cylinder 12 to move only through the single-stage driving piece. Through the multi-stage linkage, the cylinder body part 121 is driven to rotate, so that the edge locking structure 10 is stable and not prone to loosening, and the locking effect is improved. Therefore, the technical solution of the embodiment effectively solves the problem in the related art that the edge locking structure is prone to loosening, so that the locking effect is poor.

It is to be noted that the extending or retracting direction of the lock pin is determined based on which side edge of the LED frame the edge locking apparatus of the LED display screen is located. The extending direction is leftward and the retracting direction is rightward if the edge locking apparatus of the LED display screen is located on a left side edge of the LED frame, and the extending direction is rightward and the retracting direction is leftward if the edge locking apparatus of the LED display screen is located on a right side edge of the LED frame. The extending direction is upward and the retracting direction is downward if the edge locking apparatus of the LED display screen is located on an upper side edge of the LED frame. The extending direction is backward and the retracting direction is forward if the edge locking apparatus of the LED display screen is located on a rear side of the LED frame.

Specifically, the rotating piece 13 and the first rotating part 123 are able to rotate synchronously means that two first rotation stopping planes matched with each other are arranged between the rotating piece 13 and the first rotating part 123. The second driving piece 15 and the second rotating part 125 are able to rotate synchronously means that two second rotation stopping planes matched with each other are arranged between the second driving piece 15 and the second rotating part 125. The avoiding part 124 is an avoiding ring groove.

As shown in Fig. 1 to Fig. 6, the first driving piece 14 includes a first connecting rod 141 and a second connecting rod 142. A first drive shaft 126 is connected with the cylinder body part 121, the first connecting rod 141 is provided with a first limiting slot hole 1413, and the first drive shaft 126 is arranged in the first limiting slot hole 1413. The first limiting slot hole 1413 limits the movement range of the first drive shaft 126 to prevent the first drive shaft 126 from disengaging from the first connecting rod 141. A second drive shaft 131 is connected with the rotating piece 13, a first end of the second connecting rod 142 is hinged to the first connecting rod 141, a second end of the second connecting rod 142 is provided with a second limiting slot hole 1423, and the second drive shaft 131 is located in the second limiting slot hole 1423. The second limiting slot hole 1423 limits the movement range of the second drive shaft 131 to prevent the second drive shaft 131 from disengaging from the second connecting rod 142. The first connecting rod 141 is hinged to the second connecting rod 142, so that when the first driving piece 14 drives the first drive shaft 126 to move, the force is easily applied, the first drive shaft 126 is easily driven, and the operation is laborsaving.

A long axis of the first limiting slot hole 1413 is greater than a short axis of the first limiting slot hole 1413. A long axis of the second limiting slot hole 1423 is greater than a short axis of the second limiting slot hole 1423.

As shown in Fig. 1 to Fig. 11, in order to facilitate the first connecting rod 141 to apply force to the second connecting rod 142, the second connecting rod 142 drives the second drive shaft 131 to move in the second limiting slot hole 1423. The first connecting rod 141 includes a first force application rod segment 1411 and a first driving rod segment 1412 which are fixedly connected at an angle. The first end of the second connecting rod 142 is hinged to the first force application rod segment 1411, the first limiting slot hole 1413 is arranged on the first driving rod segment 1412, and the first force application rod segment 1411 drives the first driving rod segment 1412 to swing to drive the first drive shaft 126 to move, so that the cylinder body part 121 is switched between the retracting position and the inserting position. The second end of the second connecting rod 142 drives the second drive shaft 131 to move in the second limiting slot hole 1423, so that the cylinder body part 121 is switched between the inserting position and the locking position or the cylinder body part 121 is switched between the inserting position and a tensioning position (See below), and the first connecting rod 141 moves relative to the first drive shaft 126 through the first limiting slot hole 1413. In a process of switching of the cylinder body part 121 between the inserting position and the locking position, the position of the first drive shaft 126 is stationary relative to the first connecting rod 141, the long axis of the first limiting slot hole 1413 is perpendicular to an axis of the first drive shaft 126, and the position of the first drive shaft 126 does not interfere with the movement of the first connecting rod 141.

As shown in Fig. 1 to Fig. 11, in order to facilitate the second connecting rod 142 to apply force to the second drive shaft 131, the second drive shaft 131 drives the rotating piece 13 to rotate. The second connecting rod 142 includes a second force application rod segment 1421 and a second driving rod segment 1422 which are fixedly connected at an angle. The second force application rod segment 1421 is hinged to the first force application rod segment 1411, the second driving rod segment 1422 is connected with an end, away from the first force application rod segment 1411, of the second force application rod segment 1421, the second limiting slot hole 1423 is arranged on the second driving rod segment 1422, and a length direction of the second limiting slot hole 1423 is perpendicular to a length direction of the first limiting slot hole 1413.

It is to be noted that an axis of the first force application rod segment 1411, an axis of the first driving rod segment 1412 and an axis of the second force application rod segment 1421 are located in the same plane, and an axis of the second driving rod segment 1422 is perpendicular to the above plane.

As shown in Fig. 1 to Fig. 11, the lock seat 11 includes a seat body 115 and a mounting channel 117 arranged in the seat body 115. The cylinder body part 121 is movably mounted in the mounting channel 117. An axis of the mounting channel 117 is coaxial with an axis of the cylinder body part 121. The mounting channel 117 is provided with a first opening for allowing the cylinder body part 121 to pass through. The lock seat 11 further includes a cover plate 112 covering the first opening. The cover plate 112 is provided with an avoiding hole 1121 for allowing the cylinder body part 121 to pass through. A side wall of the mounting channel 117 includes a first arc-shaped concave surface 1171 in sliding fit with the rotating piece 13 and a second arc-shaped concave surface 1172 in sliding fit with the second driving piece 15. In this way, the rotation of the rotating piece 13 and the second driving piece 15 in the mounting channel 117 is smoother.

As shown in Fig. 1 to Fig. 11, the mounting channel 117 is provided with a stopper 16, and the second driving piece 15 and the rotating piece 13 are located between the stopper 16 and the cover plate 112. In this way, the second driving piece 15 and the rotating piece 13 are limited between the stopper 16 and the cover plate 112 to prevent the displacement of the second driving piece 15 and the rotating piece 13 relative to the cover plate 112 in an axial direction of the cylinder body part 121. The above structure may ensure that the positions of the second driving piece 15 and the rotating piece 13 are unchanged in the axis direction of the cylinder body part 121. When the cylinder body part 121 is in the retracting position, the first rotating part 123 and the rotating piece 13 are able to rotate synchronously, and the second driving piece 15 is in avoiding fit with the avoiding part 124. When the cylinder body part 121 is driven to move from the retracting position to the inserting position or the cylinder body part 121 is driven to move from the locking position to the inserting position, the avoiding part 124 corresponds to the rotating piece 13, the second driving piece 15 and the second rotating part 125 rotate synchronously, and the cylinder body part 121 may rotate relatively around the cylinder body part 121. The stopper 16 is preferably a convex block.

As shown in Fig. 1 to Fig. 11, the lock seat 11 is provided with a limiting groove 114 communicating with the mounting channel 117, and the limiting groove 114 is located on a side, away from the cover plate 112, of the stopper 16. The lock cylinder 12 further includes a cylinder seat 127 movably arranged in the limiting groove 114. The cylinder seat 127 is connected with an end, away from the lock pin 122, of the cylinder body part 121 through an axial limiting structure 128, and the cylinder body part 121 is rotatably arranged relative to the cylinder seat 127. Through the arrangement of the axial limiting structure 128, the axial moment of the cylinder body part 121 on the cylinder seat 127 is prevented, so that the cylinder body part 121 only rotates relative to the cylinder body part 127. The first driving piece 14 is movably arranged on the cylinder body part 121 through the cylinder seat 127, and the cylinder seat 127 is provided with a first limiting position and a second limiting position in the limiting groove 114. The cylinder body part 121 is in the retracting position when the cylinder seat 127 is in limiting fit with a side wall, away from the lock pin 122, of the limiting groove 114 to be in the first limiting position, and the cylinder body part 121 is in the inserting position when the cylinder seat 127 is in limiting fit with a side wall, close to the lock pin 122, of the limiting groove 114 to be in the second limiting position. The first drive shaft 126 is fixedly connected with the cylinder seat 127. In a process of switching of the cylinder body part 121 between the inserting position and the locking position, the position of the first drive shaft 126 is stationary relative to the first connecting rod 141, so that the cylinder body part 121 may rotate relative to the cylinder seat 127. Then, when the cylinder body part 121 is in the inserting position, the first driving piece 14 drives the rotating piece 13 to rotate to drive the second driving piece 15 and the cylinder body part 121 to rotate together.

Specifically, the axial limiting structure 128 includes a limiting ring groove 1281 arranged on the cylinder body part 121 and a limited block 1282 inserted into the limiting ring groove 1281. The limited block 1282 and the limiting ring groove 1281 are in limiting fit in the axial direction of the cylinder body part 121 to prevent the axial movement of the cylinder body part 121 relative to the cylinder seat 127.

As shown in Fig. 1 to Fig. 11, the cylinder body part 121 is further provided with the tensioning position retracting a preset distance relative to the inserting position, and an abutting structure is arranged between the rotating piece 13 and the lock seat 11. The first driving piece 14 drives the rotating piece 13 to rotate, so that on the one hand, the second driving piece 15 is driven to rotate to drive the cylinder body part 121 to rotate from the inserting position to the locking position. At this time, the first driving piece 14 drives the rotating piece 13 to rotate to drive the second driving piece 15 to achieve multi-stage linkage. On the other hand, the cylinder body part 121 is driven to move from the inserting position to the tensioning position through an abutting fit between the abutting structure and the lock seat 11. After the cylinder body part 121 rotates to the locking position, the second driving piece 15 is driven by the rotating piece 13 to stationary. In this way, the cylinder body part 121 is maintained in the locking position to prevent the second driving piece 15 from continuing to rotate with the rotation of the rotating piece 13 and avoid the second driving piece 15 from driving the cylinder body part 121 to the inserting position again. In a process of switching of the cylinder body part 121 from the inserting position to the tensioning position, the lock pin 122 pulls one of two adjacent side edges of the two adjacent LED frames to the other of two adjacent side edges of the two adjacent LED frames, or pushes the LED frame where the lock seat 11 is located to the adjacent LED frame to move, so as to lock the two adjacent LED frames together and reduce a gap between the two adjacent LED frames, thereby facilitating the adjustment of the position of the LED frame to ensure the display effect of the spliced LED display screen.

It is to be noted that the cylinder body part 121 retracting a preset distance relative to the inserting position means that the cylinder body part 121 retracts a preset distance in the lock seat 11, so that the lock pin 122 on the cylinder body part 121 pulls one of the two adjacent side edges of the two adjacent LED frames to be close to the other of two adjacent side edges of the two adjacent LED frames; or the cylinder body part 121 remains stationary, the rotating piece 13 is in abutting fit with the lock seat 11 through the abutting structure, so that the whole lock seat 11 moves relative to the cylinder body part 121 in the extending direction of the cylinder body part 121 to push the LED frame where the lock seat 11 is located to move to the adjacent LED frame.

As shown in Fig. 1 to Fig. 11, the rotating piece 13 includes a rotation stopping plate 133 sleeving the lock cylinder 12 and a first abutting inclined surface 134 arranged on the rotation stopping plate 133. The cover plate 112 is provided with a second abutting inclined surface 113 on a surface of the cover plate 112 towards the rotation stopping plate 133. The first abutting inclined surface 134 and the second abutting inclined surface 113 extend along a circumferential helix reference line of the rotation stopping plate 133. The first abutting inclined surface 134 and the second abutting inclined surface 113 form the abutting structure. The rotating piece 13 rotates to drive the cylinder body part 121 to move from the inserting position to the tensioning position through the abutting fit between the first abutting inclined surface 134 and the second abutting inclined surface 113. In order to enable the lock cylinder 12 to freely retract a certain preset distance in the lock seat 11, the axial dimension of the avoiding ring groove is greater than the axial dimension of the rotation stopping plate 133 corresponding to the avoiding ring groove.

As shown in Fig. 1 to Fig. 11, the lock seat 11 further includes a protective seat 116 arranged on a side, away from the first opening, of the cover plate 112. When the cylinder body part 121 is in the retracting position, the lock pin 122 is located in the protective seat 116, that is, retracts into the lock seat 11. In this way, the protective seat 116 protects the lock pin 122 to prevent the lock pin 122 from interfering with items outside the LED display screen. When the cylinder body part 121 is in the inserting position or the locking position or the tensioning position, the lock pin 122 is located outside the protective seat 116, that is, extends out of the lock seat 11.

As shown in Fig. 1 to Fig. 11, the second driving piece 15 includes a driving disc 151 rotatably arranged on the lock seat 11 and a third connecting rod 152 hinged between the driving disc 151 and the rotating piece 13. The driving disc 151 sleeves the lock cylinder 12. Through the arrangement of the driving disc 151, the driving disc 151 and the rotating piece 13 are linked. In order to mount the third connecting rod 152 in the lock seat 11, the lock seat 11 includes a mounting plate 111 located between the driving disc 151 and the rotating piece 13. The third connecting rod 152 is arranged on the mounting plate 111 in a swingable manner, and the driving disc 151 and the second rotating part 125 are able to rotate synchronously. When the second driving piece 15 is driven by the rotating piece 13, the rotating piece 13 rotates and drives the driving disc 151 to rotate in a direction opposite to a rotation direction of the rotating piece 13 through the third connecting rod 152, so that the cylinder body part 121 is switched between the inserting position and the locking position or the cylinder body part 121 is switched between the inserting position and the tensioning position. The third connecting rod 152 is arranged on the mounting plate 111 in a swingable manner through a pendulum shaft.

As shown in Fig. 1 to Fig. 11, a third drive shaft 132 is connected with the rotating piece 13. A first end of the third connecting rod 152 is provided with a third limiting slot hole 153. When the second driving piece 15 is driven by the rotating piece 13, the third drive shaft 132 is arranged in the third limiting slot hole 153. When the second driving piece 15 is stationary, the third drive shaft 132 is located outside the third limiting slot hole 153. When the second driving piece 15 is driven by the rotating piece 13, through the arrangement of the third limiting slot hole 153, the movement range of the third drive shaft 132 is limited, which facilitates the sliding of the third drive shaft 132 in the third limiting slot hole 153. The third drive shaft 132 is able to push the first end of the third connecting rod 152 to swing around the pendulum shaft. A fourth drive shaft 156 is connected with the driving disc 151, a second end of the third connecting rod 152 is provided with a fourth limiting slot hole 155, and the fourth drive shaft 156 is located in the fourth limiting slot hole 155. Through the arrangement of the fourth limiting slot hole 155, the movement range of the fourth drive shaft 156 is limited, which facilitates the sliding of the fourth drive shaft 156 in the fourth limiting slot hole 155. The third drive shaft 132 is able to push the second end of the third connecting rod 152 to swing around the pendulum shaft.As shown in Fig. 1 to Fig. 11, the third drive shaft 132 is fixedly arranged on a surface, deviating from the first abutting inclined surface 134, of the rotation stopping plate 133, the third limiting slot hole 153 is provided with a second opening 154 for allowing the third drive shaft 132 to move in or out, and when the second driving piece 15 is stationary, the third drive shaft 132 moves out of the second opening 154. In this way, the second driving piece 15 is driven by the rotating piece 13 to stationary, so as to avoid the second driving piece 15 from continuing to rotate with the rotating piece 13 through the third connecting rod 152. Of course, in the embodiment not shown in the figure, the third limiting slot hole is not provided with the second opening, at this time, the third drive shaft is a telescopic shaft, which moves out of the third limiting slot hole in a retracting and avoiding manner, and is located outside the third limiting slot hole in an extending and stopping manner.

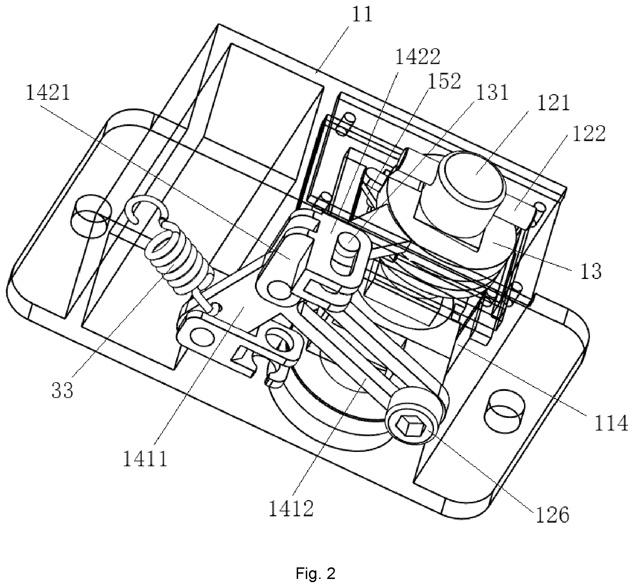

As shown in Fig. 2 to Fig. 11, the mounting plate 111 is provided with a limiting arc-shaped hole 1111 for allowing the fourth drive shaft 156 to pass through. When the fourth drive shaft 156 is in limiting fit with a first side end wall, close to the second drive shaft 131, of the limiting arc-shaped hole 1111, the cylinder body part 121 is in the inserting position. When the fourth drive shaft 156 is in limiting fit with a second side end wall, away from the second drive shaft 131, of the limiting arc-shaped hole 1111, the second driving piece 15 is stationary. In this way, the third drive shaft 132 conveniently moves out of the second opening 154 to avoid the second driving piece 15 from continuing to rotate with the rotating piece 13 through the third connecting rod 152.

As shown in Fig. 1 to Fig. 11, the edge locking apparatus of the LED display screen further includes a pulling assembly 31 arranged outside the lock seat 11 and a reset piece 33 connected between the first driving piece 14 and the lock seat 11. The reset piece 33 applies a reset force to maintain the first driving piece 14 in the retracting position. In this way, under the action of the reset force of the reset piece 33, the first driving piece 14 may automatically reset to the retracting position. An end of the pulling assembly 31 is connected with the first driving piece 14, and the pulling assembly 31 applies a pulling force to switch the first driving piece 14 from the retracting position to the inserting position. In this way, under the action of the pulling force, the cylinder body part 121 is maintained the locking position or the tensioning position to prevent the first driving piece 14 from switching from the locking position to the retracting position, avoid the looseness of the lock cylinder 12 and reduce the possibility of safety accidents. The reset piece 33 in the embodiment is preferably a tension spring.

As shown in Fig. 1 to Fig. 7, in order to facilitate the first connecting rod 141 to apply force to the second connecting rod 142, the second connecting rod 142 drives the second drive shaft 131 to move in the second limiting slot hole 1423. The first connecting rod 141 includes the first force application rod segment 1411 and the first driving rod segment 1412 which are fixedly connected at an angle. The first end of the second connecting rod 142 is hinged to the first force application rod segment 1411, the first limiting slot hole 1413 is arranged on the first driving rod segment 1412, and the first force application rod segment 1411 drives the first driving rod segment 1412 to swing to drive the first drive shaft 126 to move, so that the cylinder body part 121 is switched between the retracting position and the inserting position. The second end of the second connecting rod 142 drives the second drive shaft 131 to move in the second limiting slot hole 1423, so that the cylinder body part 121 is switched between the inserting position and the locking position or the cylinder body part 121 is switched between the inserting position and the tensioning position, and the first connecting rod 141 moves relative to the first drive shaft 126 through the first limiting slot hole 1413. In a process of switching of the cylinder body part 121 between the inserting position and the locking position, the position of the first drive shaft 126 is stationary relative to the first connecting rod 141, the long axis of the first limiting slot hole 1413 is perpendicular to an axis of the first drive shaft 126, and the position of the first drive shaft 126 does not interfere with the movement of the first connecting rod 141.

As shown in Fig. 1 to Fig. 7, in order to facilitate the second connecting rod 142 to apply force to the second drive shaft 131, the second drive shaft 131 drives the rotating piece 13 to rotate. The second connecting rod 142 includes the second force application rod segment 1421 and the second driving rod segment 1422 which are fixedly connected at an angle. The second force application rod segment 1421 is hinged to the first force application rod segment 1411, the second driving rod segment 1422 is connected with an end, away from the first force application rod segment 1411, of the second force application rod segment 1421, and the length direction of the second limiting slot hole 1423 is perpendicular to the length direction of the first limiting slot hole 1413. The second force application rod segment 1421 is hinged to the first force application rod segment 1411 through a hinge shaft.

As shown in Fig. 1 to Fig. 7, a process that the cylinder body part 121 moves from the retracting position to the inserting position, rotates from the inserting position to pass through the locking position and then moves to the tensioning position is as follows.

When the pulling assembly 31 pulls the first force application rod segment 1411 of the first driving piece 14 to swing around the hinge shaft, the pulling assembly 31 drives the first driving rod segment 1412 to swing, and pushes the first drive shaft 126 through the first limiting slot hole 1413 on the first driving rod segment 1412 to drive the first drive shaft 126 and the cylinder seat 127 to move from the first limiting position to the second limiting position in the limiting groove 114, the first drive shaft 126 drives the cylinder body part 121 to move from the retracting position to the inserting position along the axis of the cylinder body part 121, and when the first drive shaft 126 reaches the second limiting position, the cylinder body part 121 is in the inserting position. During this process, the second connecting rod 142 is stationary.

After the cylinder body part 121 reaches the inserting position, the pulling assembly 31 continues to pull the first application rod segment 1411 of the first driving piece 14. Because the first drive shaft 126 is in limiting fit with the side wall, close to the lock pin 122, of the limiting groove 114, the first drive shaft 126 and the cylinder seat 127 no longer move. At the same time, the first drive shaft 126 is in limiting fit with the side wall of the first end of the first limiting slot hole 1413, so that the first driving rod segment 1412 no longer swings. In this way, the swing performed by pulling the first force application rod segment 1411 is converted into a movement, and the first force application rod segment 1411 drives the second force application rod segment 1421 to move together. The first driving rod segment 1412 is also moved relative to the first drive shaft 126 through the first limiting slot hole 1413, and the cylinder body part 121 may rotate relative to the cylinder seat 127.

The second force application rod segment 1421 moves and drives the second driving rod segment 1422 to move synchronously, and the second limiting slot hole 1423 on the second driving rod segment 1422 drives the second drive shaft 131, so that the second drive shaft 131 drives the rotating piece 13 to rotate when moving in the second limiting slot hole 1423. On the one hand, the rotating piece 13 drives the driving disc 151 to rotate in the direction opposite to the rotation direction of the rotating piece 13 through the third connecting rod 152, so that the cylinder body part 121 rotates from the inserting position to the locking position. On the other hand, the rotating piece 13 pushes the lock seat 11 to move through the abutting fit between the first abutting inclined surface 134 and the second abutting inclined surface 113, so that the cylinder body part 121 moves from the inserting position to the tensioning position.

In a process that the rotating piece 13 drives the driving disc 151 to rotate in the direction opposite to the rotation direction of the rotating piece 13 through the third connecting rod 152, when the rotation stopping plate 133 rotates, the third drive shaft 132 abuts against the side wall of the third limiting slot hole 153 to drive the first end of the third connecting rod 152 to swing around the pendulum shaft, so that the side wall of the fourth limiting slot hole 155 on the third connecting rod 152 abuts against the fourth drive shaft 156 and drives the fourth drive shaft 156. The fourth drive shaft 156 rotates to drive the driving disc 151 to rotate in the direction opposite to the rotation direction of the rotation stopping plate 133. When the fourth drive shaft 156 is in limiting fit with the second side end wall, away from the second drive shaft 131, of the limiting arc-shaped hole 1111 on the mounting plate 111, the fourth drive shaft 156 no longer rotates, and the driving disc 151 is stationary. At this time, the cylinder body part 121 reaches the locking position.

In a process that the rotating piece 13 pushes the lock seat 11 to move through the abutting fit between the first abutting inclined surface 134 and the second abutting inclined surface 113, when the rotation stopping plate 133 rotates, the first abutting inclined surface 134 on the rotation stopping plate 133 is in abutting fit with the second abutting inclined surface 113 to push the cover plate 112 to move in the extending direction of the cylinder body part 121. In this process, the third drive shaft 132 is removed from the second opening 154 and no longer drives the third connecting rod 152 to swing, that is, after the cylinder body part 121 reaches the locking position, the cylinder body part 121 remains relatively stationary, the rotation stopping plate 133 only drives the lock seat 11 to move subsequently until the two adjacent LED frames are in contact, and when there is no gap between the two adjacent LED frames, the cylinder body part 121 moves from the relative inserting position to the tensioning position.

It is to be noted that when the rotating piece 13 drives the driving disc 151 to rotate in the direction opposite to the rotation direction of the rotating piece 13 through the third connecting rod 152, the cylinder body part 121 rotates from the inserting position to the locking position, which facilitates the rotation of the cylinder body part 121 to the locking position. At this time, the first driving piece 14 drives the rotating piece 13 to rotate to drive the second driving piece 15 to rotate, so that multi-stage linkage may be achieved. Furthermore, the two LED frames are blocked to each other when in contact, the cylinder body part 121, after reaching the locking position, does not need to continue to move to the tensioning position, and at this time, the cylinder body part 121 is maintained in the locking position.

As shown in Fig. 1 to Fig. 8, the pulling assembly 31 includes a pulling seat 311, a pulling plate 312 and a pulling wire 313. The pulling seat 311 is arranged outside the lock seat 11, the pulling plate 312 is rotatably arranged on the pulling seat 311, a first end of the pulling wire 313 is connected with the first driving piece 14, a second end of the pulling wire 313 is connected with the pulling plate 312 through a connecting shaft 314, the connecting shaft 314 and a rotating axis of the pulling plate 312 are arranged at intervals, so that the second end of the pulling wire 313 rotates around the rotating axis of the pulling plate 312, and the pulling wire 313 applies a pulling force to the first driving piece 14. In this way, the pulling plate 312 rotates on the pulling seat 311 to pull the pulling wire 313, so that the pulling plate 312 drives the second end of the pulling wire 313 to rotate around the rotating axis of the pulling plate 312 through the connecting shaft 314, and then the pulling wire 313 applies the pulling force to the first driving piece 14, so that the cylinder body part 121 moves from the retracting position to the inserting position, and then passes through the locking position when moving from the inserting position to the tensioning position. Conversely, the reset piece 33 pulls the first driving piece 14 to apply the reset force to the first driving piece 14, so that the first driving piece 14 drives the cylinder body part 121 to pass through the locking position when moving from the tensioning position to the inserting position, and then move from the inserting position to the retracting position.

As shown in Fig. 1 to Fig. 8, the pulling assembly 31 further includes a stop structure 32 spaced apart from the pulling seat 311. The stop structure 32 includes a stop seat 321 and a stop pin 322 movably arranged on the stop seat 321. Both ends of the pulling plate 312 are respectively provided with a first socket 315 and a second socket 316 matched with the stop pin 322, and the connecting shaft 314 is located between the rotating axis of the pulling plate 312 and the second socket 316. When the pulling plate 312 driven by the reset force rotates counterclockwise around the rotating axis of the pulling plate 312 to a position, corresponding to the first socket 315, of the stop pin 322, and the stop pin 322 is inserted into the first socket 315, the cylinder body part 121 is maintained in the retracting position under the action of the reset force. When the pulling plate 312 driven manually or by means of a tool rotates clockwise around the rotating axis of the pulling plate 312 to a position, corresponding to the second socket 316, of the stop pin 322, and the stop pin 322 is inserted into the second socket 316, the cylinder body part 121 is maintained in the locking position or the tensioning position under the action of the pulling force. In the embodiment, the pulling plate 312 may rotate by 180 degrees, and when the first socket 315 and the second socket 316 on the pulling plate 312 are matched with the stop pin 322 respectively, the cylinder body part 121 is conveniently switched between the retracting position and the locking position or the cylinder body part 121 is conveniently switched between the retracting position and the tensioning position, which is convenient to operate and easy to implement. When the cylinder body part 121 is maintained in the locking position or the tensioning position, the stability of locking is enhanced when the edge locking apparatus of the LED display screen is in insertion fit. At the same time, when the cylinder body part 121 is maintained in the retracting position, the edge locking apparatus of the LED display screen is not loosened on the LED frame, which may enhance the stability of mounting.

In the embodiment, the stop seat 321 is provided with a guide hole for allowing the stop pin 322 to pass through. An elastic piece 323 is arranged in the stop seat 321. The elastic piece 323 sleeves the stop pin 322 and is located between the stop pin 322 and an inner wall of the stop seat 321. The elastic piece 323 applies an elastic force towards the pulling plate 312 to the stop pin 322, so that the pulling plate 312 is in the process of turning 180 degrees, after the stop pin 322 is manually driven or the stop pin 322 is extruded by the pulling plate 312, the stop pin 322 does not interfere with the rotation of the pulling plate 312, the stop pin 322 retracts backwards a certain distance in the stop seat 321. When the pulling plate 312 rotates to the position, corresponding to the stop pin 322, of the first socket 315 or the second socket 316, the stop pin 322 is inserted into the first socket 315 or the second socket 316 under the action of the elastic force.

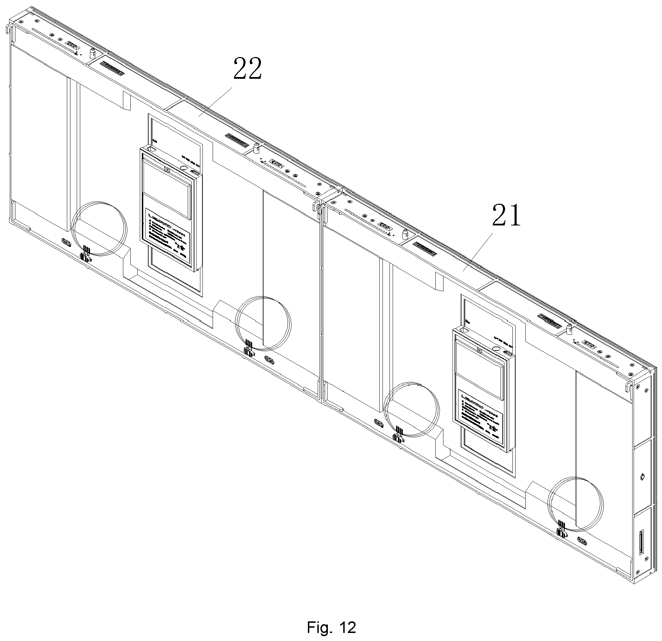

The invention further provides an LED display screen, as shown in Fig. 12 to Fig. 15, the LED display screen in the embodiment includes a first LED frame 21, a second LED frame 22 and an edge locking apparatus. The first LED frame 21 and the second LED frame 22 are arranged side by side, and the first LED frame 21 is one of the two adjacent LED frames, and the second LED frame 22 is the other of the two adjacent LED frames. The edge locking apparatus is the above edge locking apparatus of the LED display screen, an edge locking structure 10 of the edge locking apparatus is mounted on a first side edge, adjacent to the second LED frame 22, of the first LED frame 21, a second side edge, adjacent to the first LED frame 21, of the second LED frame 22 is provided with a lock hole 23 for allowing a lock pin 122 of the edge locking structure 10 to pass through, and when a cylinder body part 121 is in a locking position, the lock pin 122 and the lock hole 23 are staggered and in stopping fit with the second side edge. Because the edge locking apparatus of the LED display screen solves the problem in the related art that the edge locking structure is prone to loosening, so that the locking effect is poor, the LED display screen with the edge locking apparatus solves the same technical problem.

The invention further provides an LED display screen, as shown in Fig. 12 to Fig. 15, the LED display screen in the embodiment includes a first LED frame 21, a second LED frame 22 and an edge locking apparatus. The first LED frame 21 and the second LED frame 22 are arranged side by side, the edge locking apparatus is the above edge locking apparatus of the LED display screen, an edge locking structure 10 of the edge locking apparatus is mounted on a first side edge, adjacent to the second LED frame 22, of the first LED frame 21, and a pulling assembly 31 of the edge locking apparatus is mounted on a third side edge 211, adjacent to the first side edge, of the first LED frame 21.

Specifically, the third side edge 211 is provided with a first through hole and a second through hole arranged at intervals, a pulling plate 312 is located in the first through hole, part of a stop pin 322 is located in the second through hole, and the outside of the first LED frame 21 may be in contact with the pulling plate 312 through the first through hole, and the outside of the first LED frame 21 may be in contact with the stop pin 322 through the second through hole. One end of the pulling plate 312 is driven manually or by means of a tool through the first through hole to rotate clockwise around a rotating axis of the pulling plate 312, the other end of the pulling plate 312 rotates to the outside of the first LED frame 21 through the first through hole, so that the other end of the pulling plate 312 is manually driven to rotate, so as to rotate the pulling plate 312 to the position, corresponding to the stop pin 322, of the first socket 315 or the second socket 316 on the pulling plate 312.

It is to be noted that the terms used herein is only for the purpose of describing the specific implementations and is not intended to limit the exemplary implementations of the invention. As used herein, the singular form is also intended to include the plural form unless otherwise expressly stated in the context, and it should also be understood that when the terms "contain" and/or "include" are used in the specification, they indicate the presence of features, steps, operations, devices, components and/or combinations thereof.

Furthermore, it is to be noted that the use of the words "first", "second" and the like to define parts is only for the convenience of distinguishing the corresponding parts, unless otherwise stated, the words have no special meaning, and therefore cannot be construed as limiting the scope of protection of the invention.

The above is only the preferred embodiments of the invention, and is not intended to limit the invention, and for those of ordinary skill in the art, various modifications and changes may be made to the invention. Any modifications, equivalent substitutions, improvements, etc. within the spirit and scope of the invention shall be included in the scope of protection of the invention.

## Claims

1. An edge locking apparatus of a Light Emitting Diode (LED) display screen, comprising an edge locking structure (10), wherein the edge locking structure (10) comprises:
a lock seat (11);
a lock cylinder (12), movably arranged in the lock seat (11), the lock cylinder (12) comprising a cylinder body part (121), and a lock pin (122), a first rotating part (123), an avoiding part (124) and a second rotating part (125) which are sequentially arranged on the cylinder body part (121) at intervals, the cylinder body part (121) being provided with a retracting position enabling the lock pin (122) to retract into the lock seat (11), an inserting position enabling the lock pin (122) to extend out of the lock seat (11) and a locking position enabling the lock pin to rotate by a preset angle relative to the inserting position;
a rotating piece (13) rotatably arranging on the lock seat (11), and the rotating piece (13) and the first rotating part (123) are able to rotate synchronously;
a first driving piece (14), which is movably arranged on the cylinder body part (121) and drives the cylinder body part (121) to move in an extending or retracting direction of the lock pin (122), when the cylinder body part (121) is in the retracting position, the first rotating part (123) and the rotating piece (13) rotate synchronously, and when the cylinder body part (121) is in the inserting position, the avoiding part (124) corresponds to the rotating piece (13); and
a second driving piece (15), which is rotatably arranged on the lock seat (11) and a second driving piece (15) and the second rotating part (125) are able to rotate synchronously, when the cylinder body part (121) is in the inserting position, the second driving piece (15) and the second rotating part (125) rotate synchronously, and the first driving piece (14) drives the rotating piece (13) to rotate to drive the second driving piece (15) to rotate, so that the cylinder body part (121) rotates from the inserting position to the locking position.

2. The edge locking apparatus of the LED display screen according to claim 1, wherein the first driving piece (14) comprises a first connecting rod (141) and a second connecting rod (142), wherein a first drive shaft (126) is connected with the cylinder body part (121), the first connecting rod (141) is provided with a first limiting slot hole (1413), the first drive shaft (126) is arranged in the first limiting slot hole (1413), a second drive shaft (131) is connected with the rotating piece (13), a first end of the second connecting rod (142) is hinged to the first connecting rod (141), a second end of the second connecting rod (142) is provided with a second limiting slot hole (1423), and the second drive shaft (131) is located in the second limiting slot hole (1423).

3. The edge locking apparatus of the LED display screen according to claim 2, wherein the first connecting rod (141) comprises a first force application rod segment (1411) and a first driving rod segment (1412) which are fixedly connected at an angle, wherein the first end of the second connecting rod (142) is hinged to the first force application rod segment (1411), the first limiting slot hole (1413) is arranged on the first driving rod segment (1412), and the first force application rod segment (1411) drives the first driving rod segment (1412) to swing to drive the first drive shaft (126) to move, so that the cylinder body part (121) is switched between the retracting position and the inserting position; and the second end of the second connecting rod (142) drives the second drive shaft (131) to move in the second limiting slot hole (1423), so that the cylinder body part (121) is switched between the inserting position and the locking position, and the first connecting rod (141) moves relative to the first drive shaft (126) through the first limiting slot hole (1413).

4. The edge locking apparatus of the LED display screen according to claim 3, wherein the second connecting rod (142) comprises a second force application rod segment (1421) and a second driving rod segment (1422) which are fixedly connected at an angle, wherein the second force application rod segment (1421) is hinged to the first force application rod segment (1411), the second driving rod segment (1422) is connected with an end, away from the first force application rod segment (1411), of the second force application rod segment (1421), the second limiting slot hole (1423) is arranged on the second driving rod segment (1422), and a length direction of the second limiting slot hole (1423) is perpendicular to a length direction of the first limiting slot hole (1413).

5. The edge locking apparatus of the LED display screen according to claim 1, wherein,
the lock seat (11) comprises a seat body (115) and a mounting channel (117) arranged in the seat body (115), wherein the cylinder body part (121) is movably mounted in the mounting channel (117), and the mounting channel (117) is provided with a first opening for allowing the cylinder body part (121) to pass through; the lock seat (11) further comprises a cover plate (112) covering the first opening, the cover plate (112) being provided with an avoiding hole (1121) for allowing the cylinder body part (121) to pass through; a side wall of the mounting channel (117) comprises a first arc-shaped concave surface (1171) in sliding fit with the rotating piece (13) and a second arc-shaped concave surface (1172) in sliding fit with the second driving piece (15); and
the mounting channel (117) is provided with a stopper (16), and the second driving piece (15) and the rotating piece (13) are located between the stopper (16) and the cover plate (112).

6. The edge locking apparatus of the LED display screen according to claim 5, wherein the lock seat (11) is provided with a limiting groove (114) communicating with the mounting channel (117), and the limiting groove (114) is located on a side, away from the cover plate (112), of the stopper (16); the lock cylinder (12) further comprises a cylinder seat (127) movably arranged in the limiting groove (114), wherein the cylinder seat (127) is connected with an end, away from the lock pin (122), of the cylinder body part (121) through an axial limiting structure (128), and the cylinder body part (121) is rotatably arranged relative to the cylinder seat (127); the first driving piece (14) is movably arranged on the cylinder body part (121) through the cylinder seat (127), the cylinder seat (127) is provided with a first limiting position and a second limiting position in the limiting groove (114); and when the cylinder seat (127) is in the first limiting position, the cylinder body part (121) is in the retracting position, and when the cylinder seat (127) is in the second limiting position, the cylinder body part (121) is in the inserting position.

7. The edge locking apparatus of the LED display screen according to claim 6, wherein the axial limiting structure (128) comprises a limiting ring groove (1281) arranged on the cylinder body part (121) and a limited block (1282) inserted into the limiting ring groove (1281), the limited block (1282) and the limiting ring groove (1281) being in limiting fit in an axial direction of the cylinder body part (121).

8. The edge locking apparatus of the LED display screen according to claim 1, wherein the second driving piece (15) comprises a driving disc (151) rotatably arranged on the lock seat (11) and a third connecting rod (152) hinged between the driving disc (151) and the rotating piece (13), wherein the driving disc (151) sleeves the lock cylinder (12); the lock seat (11) comprises a mounting plate (111) located between the driving disc (151) and the rotating piece (13); the third connecting rod (152) is arranged on the mounting plate (111) in a swingable manner, the driving disc (151) and the second rotating part (125) are able to rotate synchronously, when the second driving piece (15) is driven by the rotating piece (13), the rotating piece (13) rotates and drives the driving disc (151) to rotate in a direction opposite to a rotation direction of the rotating piece (13) through the third connecting rod (152), so that the cylinder body part (121) is switched between the inserting position and the locking position.

9. The edge locking apparatus of the LED display screen according to claim 8, wherein a third drive shaft (132) is connected with the rotating piece (13), a first end of the third connecting rod (152) is provided with a third limiting slot hole (153), the third drive shaft (132) is arranged in the third limiting slot hole (153), a fourth drive shaft (156) is connected with the driving disc (151), a second end of the third connecting rod (152) is provided with a fourth limiting slot hole (155), and the fourth drive shaft (156) is arranged in the fourth limiting slot hole (155).

10. The edge locking apparatus of the LED display screen according to claim 1, further comprising a pulling assembly (31) arranged outside the lock seat (11) and a reset piece (33) connected between the first driving piece (14) and the lock seat (11), wherein the reset piece (33) applies a reset force to maintain the first driving piece (14) in the retracting position, an end of the pulling assembly (31) is connected with the first driving piece (14), and the pulling assembly (31) applies a pulling force to switch the first driving piece (14) from the retracting position to the inserting position.

11. The edge locking apparatus of the LED display screen according to claim 10, wherein,
the pulling assembly (31) comprises a pulling seat (311), a pulling plate (312) and a pulling wire (313), wherein the pulling seat (311) is arranged outside the lock seat (11), the pulling plate (312) is rotatably arranged on the pulling seat (311), a first end of the pulling wire (313) is connected with the first driving piece (14), a second end of the pulling wire (313) is connected with the pulling plate (312) through a connecting shaft (314), the connecting shaft (314) and a rotating axis of the pulling plate (312) are arranged at intervals, so that the second end of the pulling wire (313) rotates around the rotating axis of the pulling plate (312), and the pulling wire (313) applies a pulling force to the first driving piece (14); and
the pulling assembly (31) further comprises a stop structure (32) spaced apart from the pulling seat (311), and the stop structure (32) comprises a stop seat (321) and a stop pin (322) movably arranged on the stop seat (321), wherein both ends of the pulling plate (312) are respectively provided with a first socket (315) and a second socket (316) matched with the stop pin (322), the connecting shaft (314) is located between the rotating axis of the pulling plate (312) and the second socket (316), when the stop pin (322) is inserted into the first socket (315), the cylinder body part (121) is maintained in the retracting position under an action of the reset force, and when the stop pin (322) is inserted into the second socket (316), the cylinder body part (121) is maintained in the locking position under an action of the pulling force.

12. A Light Emitting Diode (LED) display screen, comprising a first LED frame (21), a second LED frame (22) and an edge locking apparatus, wherein the first LED frame (21) and the second LED frame (22) are arranged side by side or up-down, the edge locking apparatus is the edge locking apparatus of the LED display screen according to any one of claims 1 to 11, an edge locking structure (10) of the edge locking apparatus is mounted on a first side edge, adjacent to the second LED frame (22), of the first LED frame (21), a second side edge, adjacent to the first LED frame (21), of the second LED frame (22) is provided with a lock hole (23) for allowing a lock pin (122) of the edge locking structure (10) to pass through, and when a cylinder body part (121) is in a locking position, the lock pin (122) and the lock hole (23) are staggered and in stopping fit with the second side edge.

13. A Light Emitting Diode (LED) display screen, comprising a first LED frame (21), a second LED frame (22) and an edge locking apparatus, wherein the first LED frame (21) and the second LED frame (22) are arranged side by side or up-down, the edge locking apparatus is the edge locking apparatus of the LED display screen according to claim 11, an edge locking structure (10) of the edge locking apparatus is mounted on a first side edge, adjacent to the second LED frame (22), of the first LED frame (21), and a pulling assembly (31) of the edge locking apparatus is mounted on a third side edge (211), adjacent to the first side edge, of the first LED frame (21).
